# FASCICULE DE BREVET EUROPEEN

(11) **EP 3 127 173 B1**
(45) Date de publication et mention de la délivrance du brevet: **11.09.2019**
(21) Numéro de dépôt: 15716461.7
(22) Date de dépôt: 31.03.2015
(51) Int. Cl.: H01L 41/45, H01L 41/27, H01L 41/297, H01L 41/193, H01L 41/047, H01L 41/083

(54) **ACTIONNEUR ÉLECTROACTIF ET PROCÉDÉ DE RÉALISATION**
ELEKTROAKTIVER AKTUATOR UND VERFAHREN ZU DESSEN HERSTELLUNG
ELECTROACTIVE ACTUATOR AND METHOD FOR ITS PRODUCTION

(30) Priorité: 31.03.2014 FR 1452837
(43) Date de publication de la demande: 08.02.2017
(73) Titulaire: Commissariat à l'Énergie Atomique et aux Énergies Alternatives, 75015 Paris (FR)
(72) Inventeur: ALIANE, Abdelkader, F-38100 Grenoble (FR); BENWADIH, Mohammed, F-94500 Champigny sur Marne (FR)
(74) Mandataire: Hautier, Nicolas
(86) Numéro de dépôt international: PCT/EP2015/057117
(87) Numéro de publication internationale: WO 2015/150425

(56) Documents cités:
- WO-A1-2015/071567
- WO-A2-2012/118916
- KR-A- 20100 046 641
- US-A1- 2010 007 285
- US-A1- 2012 200 200
- US-B1- 6 423 412
- TOMER V ET AL: "High field properties and energy storage in nanocomposite dielectrics of poly(vinylidene fluoride-hexafluoropropylene)", JOURNAL OF APPLIED PHYSICS, AMERICAN INSTITUTE OF PHYSICS, US, vol. 110, no. 4, 15 août 2011 (2011-08-15) , pages 44107/1-44107/10, XP012150708, ISSN: 0021-8979, DOI: 10.1063/1.3609082 [extrait le 2011-08-23]

## Description

### DOMAINE TECHNIQUE DE L'INVENTION

L'invention concerne le domaine des actionneurs électroactifs ou dispositifs haptiques reposant sur un polymère électroactif. Elle concerne également les dispositifs microélectroniques comprenant un ou plusieurs actionneurs électroactifs. L'invention trouve par exemple pour application particulièrement avantageuse le domaine des téléphones intelligents, des interrupteurs et des dispositifs comprenant une optique tels que les appareils photos ou caméras vidéo.

### ÉTAT DE LA TECHNIQUE

Les actionneurs électroactifs peuvent par exemple être utilisés dans les caméras pour la fonction zoom, dans la fabrication d'interrupteur, dans la robotique et dans la fabrication de tissu musculaire intelligent basé sur l'effet haptique. En outre, ce type d'actionneur peut être utilisé dans les tablettes tactiles. Le polymère souvent utilisé dans ces dispositifs est à base de P(VDF-TrFe-CFE) (Poly(fluore de vinylidène-Trifluoroéthylène-chloro-fluoroéthylène) ou de P(VDF-TrFe-CTFE) (Poly (fluorure de vinylidène-Trifluoroéthylène-chloro trifluoroéthylène)). Ce type de polymère répond par un déplacement si on lui applique un champ électrique suffisant. Le champ électrique pour avoir un déplacement minimum, par exemple de 100 nm, est très élevé (de l'ordre de 30V/µm).

Afin de diminuer cette tension minimale à appliquer, souvent qualifiée de tension de réveil, une solution consiste à augmenter la capacitance électrique totale du dispositif en empilant en parallèle plusieurs capacités. Chaque capacité est formée de l'empilement électrode métallique/polymère/électrode métallique. Le problème majeur de cette solution est la limitation technologique actuelle à 2 ou 3 couches de polymères.

En effet, la fabrication de ces dispositifs requiert un recuit thermique standard (typiquement 115°C durant 30 à 60 minutes) afin de cristalliser le polymère. Une bonne cristallisation du polymère est en effet nécessaire pour qu'il soit électro-actionnable. Cette cristallisation nécessite un recuit dédié à chacune des couches polymère déposées. Au fur et à mesure de l'empilement des capacités, on effectue donc des recuits successifs pour un même dispositif électroactif. Ces recuits successifs créent des fissurations sur les couches sous-jacentes à cause des différences de contraintes entre le polymère et le métal déposé, les coefficients de dilatations thermiques étant différents entre le polymère et l'électrode métallique. De plus, lors du recuit des couches sous-jacentes, les couches de polymère électroactif, déjà cristallisées, subissent un recuit supplémentaire dégradant leur structure cristalline et donc leurs propriétés électroactives.

Une solution au problème de fissuration a été décrite dans le document de JUNG publié sous le numéro US2012/0200200A1. Ce document décrit la fabrication d'une électrode en polymère intégrée dans un dispositif actionneur à base de P(VDF-TrFe-CFE) ou de P(VDF-TrFe-CTFE). L'électrode conductrice est à base de polymères comme le PEDOT : PSS ((poly(3,4-éthylène dioxy thiophène) (PEDOT) :poly(styrène sulfonate) (PSS)) ou du polyaniline avec l'eau comme solvant. L'objectif de ce document est de former une surface hydrophile sur le substrat pour pouvoir recevoir l'électrode en polymère conducteur à base d'eau (donc hydrophile). Le fait d'utiliser des électrodes en polymères permettrait de réduire les différences de contraintes lors du recuit dans le dispositif multicouche, les électrodes en polymère conducteur ayant les mêmes caractéristiques mécaniques que les couches de polymère électroactif.

Cette solution n'est pas dénuée d'inconvénient. En effet, on a constaté avec cette solution une forte dégradation dans le temps des actionneurs car le PEDOT : PSS se détériore très fortement par l'humidité et sa résistance électrique augmente alors. Il faut alors parfaitement encapsuler l'ensemble du dispositif ou réserver son application à des domaines supprimant toute présence d'humidité ce qui est très contraignant.

Enfin une seconde problématique liée à cette solution est la nécessité d'appliquer des tensions électriques sur l'ensemble de l'empilement dans un premier temps pour activer les sites conducteurs des couches en PEDOT : PSS.

Une autre solution a été proposée par CHOI dans le document US2012/0139393A1, qui décrit un empilement à base de ce même polymère pour la fabrication d'un actionneur électroactif avec une faible tension d'alimentation. Pour cela, ce document prévoit d'utiliser une couche de protection pour le polymère électroactif lors de l'empilement en parallèle. Cette couche de protection évite que le solvant de la couche de polymère électroactif surmontant une couche inférieure puisse dégrader (en la faisant dissoudre) la couche inférieure de polymère électroactif. L'inconvénient de ce procédé est l'introduction de capacités parasites lors du fonctionnement de l'actionneur. Une autre solution a été proposée par EGRON dans le document WO2012/118916.

Un objet de la présente invention est donc de proposer une solution pour obtenir un actionneur électroactif dont la tension d'actionnement est réduite tout en limitant à la fois les contraintes relatives à l'humidité et à l'ajout d'une capacité parasite.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Selon un mode de réalisation, l'invention porte sur un procédé de fabrication d'un actionneur électroactif à partir d'un empilement comprenant au moins une première électrode et au moins une couche électroactive comprenant un polymère électroactif surmontant la première électrode, la couche électroactive ayant la capacité de répondre par un déplacement et d'entrainer avec elle au moins la première électrode lorsqu'on lui applique un champ électrique, le procédé comprenant :
- une étape de cristallisation de la couche électroactive surmontant l'empilement ;
- une étape de formation d'une deuxième électrode de manière à ce que la couche électroactive soit disposée entre les deux électrodes.

Le polymère électroactif est formé d'un matériau apte à se cristalliser au moins en partie sous l'effet d'une d'exposition à un rayonnement ultra-violet (UV). Par ailleurs, l'étape de cristallisation comprend une étape d'exposition de la couche électroactive à un rayonnement ultra-violet au cours de laquelle une partie au moins et de préférence tout le rayonnement ultra-violet est délivré sous forme d'une ou plusieurs impulsions. Cette étape d'exposition à un rayonnement UV peut être qualifiée d'UV Flash.

Dans le cadre du développement de la présente invention, il s'est avéré que cette technique d'exposition comprenant une exposition par impulsions, et donc discontinue, à un rayonnement UV, permet de cristalliser très efficacement le polymère électro-actionnable. En outre, il a été constaté que cette étape ne génère pas dans les couches électroactives sous-jacentes ou dans les électrodes sous-jacentes, une augmentation de la température ou génère une augmentation de température limitée en amplitude et cantonnée à une faible profondeur. Ainsi, l'invention évite que l'ensemble des couches électroactives ne subisse l'élévation de température imposée, dans les solutions existantes, par le recuit visant à cristalliser la couche dernièrement déposée.

Les risques d'apparition de fissures dues aux différences de coefficient de température entre les électrodes métalliques et la couche électroactive sont donc évités.

Par ailleurs, il est possible d'empiler plusieurs couches électroactives séparées par des électrodes. Dans ce cas, les couches électroactives inférieures n'étant pas soumises à une élévation de la température lors de la cristallisation de la couche supérieure, l'état cristallin de ces couches électroactives inférieures n'est pas dégradé lors de la cristallisation des couches déposées ensuite.

L'invention permet ainsi d'accroitre significativement le nombre de couches électroactives dans un empilement et donc d'améliorer considérablement les performances des dispositifs haptiques. Alors qu'en pratique, les solutions existantes obligent de se limiter à environ 2 ou 3 couches électroactives, un dispositif réalisé en mettant en oeuvre l'invention peut facilement présenter plus de 3, voire plus de 5 voire plus de 10 couches électroactives.

En outre, cette structure n'impose pas un matériau polymère non métallique pour les électrodes. Cette structure est donc significativement moins sensible à l'humidité que celle mentionnée dans la section relative à l'art antérieur et reposant sur des électrodes non métalliques et formées dans un polymère.

Enfin, l'invention évite l'introduction de capacités parasites.

Il est précisé dans le cadre de la présente invention qu'une exposition par impulsion d'une couche pendant une durée d'exposition très brève à un rayonnement UV peut être qualifiée d'UV Flash. La durée de chaque impulsion est inférieure à 100 millisecondes. L'utilisation d'impulsions de cette durée et non d'un flux continu de rayonnement ultra-violet diminue la dissipation de la chaleur à l'intérieur du polymère et permet ainsi d'éviter la détérioration du polymère. L'énergie apportée par l'impulsion assure un échauffement uniquement local et rapide du polymère.

De manière facultative, l'invention peut en outre présenter au moins l'une quelconque des caractéristiques suivantes prises séparément ou en combinaison :
- Avantageusement, la durée de chaque impulsion est inférieure à 10 ms et de préférence inférieure à 5 ms et de préférence inférieure à 3 ms. Avantageusement, la durée de chaque impulsion est comprise entre 0.025 ms et 2 ms. Par exemple elle est comprise entre 0.5 ms et 2 ms. Ces intervalles permettent une cristallisation particulièrement efficace de la couche qui reçoit le rayonnement en premier lieu tout en limitant très fortement, voire tout en empêchant la propagation de la chaleur dans les couches sous-jacentes. Ces intervalles permettent ainsi à chacune des couches d'être performante sans pour autant dégrader les performances des couches sous-jacentes. Une exposition de ce type permet par conséquent d'améliorer considérablement les performances de l'électro actionneur.
- L'étape de cristallisation comprend une étape d'exposition de la couche électroactive à un rayonnement ultra-violet uniquement et alternativement à un rayonnement comprenant un rayonnement ultra-violet et éventuellement un rayonnement hors de l'UV.
- La longueur d'onde des rayonnements ultra-violets est comprise entre 200 nm et 800 nm. (ms, 10⁻³ secondes).
- Avantageusement au cours de l'étape d'exposition le rayonnement ultra-violet est délivré sous forme d'une seule impulsion.
- Alternativement au cours de l'étape d'exposition le rayonnement UV est délivré sous forme d'une pluralité d'impulsions.
- Selon un exemple la durée d'exposition cumulant la durée de chacune des impulsions est inférieure à 1s et de préférence inférieure à 500 ms.
- Avantageusement le rayonnement ultra-violet est uniquement délivré sous forme de ladite ou desdites impulsions. Afin de permettre un refroidissement du polymère entre deux impulsions, lesdites impulsions sont espacées dans le temps.
- Avantageusement, au cours de l'étape d'exposition le rayonnement ultra-violet est délivré sous forme d'une ou plusieurs impulsions, la fluence de chacune des impulsions étant inférieure à 50 j/cm² et de préférence étant comprise entre 2 j/cm² et 40 j/cm² et de préférence entre 5 j/cm² et 30 j/cm² et de préférence entre 15 j/cm² et 20 j/cm².

La variation de fluence est nécessaire dès lors que l'épaisseur de la couche électroactive varie. Cette adaptation de la fluence à l'épaisseur garanti une très bonne cristallisation de la couche électroactive quel que soit son épaisseur.
- Selon un exemple, l'étape de cristallisation ne comporte que ladite étape d'exposition.
- Selon un exemple, la couche électroactive est uniquement constituée du polymère électroactif.
- Selon un exemple, à partir de l'empilement comprenant au moins une couche comprenant un polymère électroactif disposée entre deux électrodes, on effectue les séquences suivantes :
   ∘ Formation d'une couche additionnelle de polymère électroactif surmontant ledit empilement ;
   ∘ Obtention d'une couche électroactive additionnelle par cristallisation de ladite couche additionnelle de polymère électroactif, la cristallisation comprenant une étape d'exposition de la couche additionnelle de polymère électroactif à un rayonnement UV, l'étape d'exposition comprenant une ou plusieurs impulsions;
   ∘ Formation d'une électrode surmontant ladite couche électroactive additionnelle.

On obtient ainsi un empilement de couches électroactives ayant chacune subi une étape d'exposition comprenant une ou plusieurs impulsions et chacune située entre deux électrodes. La répétition de cette séquence et ses avantages permettent de ne plus être limité à 2 ou 3 couches électroactives, mais d'en empiler autant que nécessaire.
- Avantageusement, ladite séquence est réitérée de manière à obtenir un empilement d'une pluralité de couches électroactives ayant chacune fait l'objet d'une étape d'exposition UV distincte et chacune située entre deux électrodes.
- Avantageusement, la pluralité de couches électroactives comporte au moins trois couches électroactives et de préférence cinq couches électroactives.
- De préférence, L'empilement repose sur un substrat suffisamment flexible pour suivre le déplacement de l'empilement.
- De préférence, les substrats utilisés sont pris par exemple parmi les matériaux suivant : PEN (polyéthylènenaphtalate), PET (polyéthylène téréphtalate), Kapton (polyimide) ou Peek (poly éther éther kétone). Ces matériaux sont mécaniquement flexibles et chimiquement inertes. Ils possèdent un faible module de Young, sont flexibles, légers et conformables.
- Avantageusement, l'épaisseur des substrats est comprise entre 5 µm et 300 µm, de préférence entre 5 µm et 200 µm et de préférence entre 5 µm et 50 µm.
- Avantageusement, au moins certaines des électrodes de l'actionneur sont des électrodes métalliques.
- Avantageusement, les matériaux utilisés pour les électrodes métalliques comprennent ou sont formées d'un matériau parmi : l'or, l'argent, le platine, l'aluminium, le nickel, le palladium, le cuivre ou l'oxyde d'indium-étain.
- Avantageusement, au moins certaines des électrodes de l'actionneur sont en graphène ou sont formées à partir d'encre d'argent en nanofils.
- Avantageusement, l'épaisseur de la couche métallique est comprise entre 10 nm et 8 µm et de préférence entre 10 nm et 1 µm.
- De préférence, les procédés de dépôt des couches métalliques utilisés sont par exemple : dépôt physique en phase vapeur (PVD), jet d'encre, sérigraphie ou pulvérisation par ultrasons.
- De préférence, les couches électroactives sont en Poly(fluore de vinylidène-Trifluoroéthylène-chloro-fluoroéthylène (P(VDF-TrFe-CFE)) ou en Poly (fluorure de vinylidène-Trifluoroéthylène-chloro trifluoroéthylène) (P(VDF-TrFe-CTFE)). Ces polymères sont électroactifs. Ces polymères possèdent un faible module de Young, une forte constante diélectrique et une forte déformation lors de l'application d'un champ électrique. Le polymère électroactif n'est pas électriquement conducteur. On peut le qualifier de diélectrique.
- Avantageusement, l'épaisseur de la couche électroactive est comprise entre 100 nm et 10 µm, et de préférence entre 100 nm et 4 µm.
- De préférence, les procédés de dépôt des couches électroactives utilisés sont par exemple : tournette (spin coating), jet d'encre, sérigraphie ou pulvérisation par ultrasons (spray).
- Selon un exemple, l'empilement comprend plusieurs couches électroactives et après cristallisation d'une couche électroactive inférieure et avant la formation d'une deuxième couche électroactive supérieure surmontant la couche électroactive inférieure, on réalise une couche de blocage des UV disposée entre les couches électroactives inférieures et supérieures. La couche de blocage comporte au moins un composé non métallique absorbant ou bloquant les UV, de manière à ce que la couche de blocage des UV bloque une partie au moins des UV traversant la couche électroactive supérieure et se dirigeant vers la couche électroactive inférieure.
- Avantageusement, le composé non métallique absorbant forme avec les atomes de l'électrode, typiquement des atomes de métal, des liaisons covalentes qui bloquent ou absorbent les UV. Ainsi, l'exposition UV appliquée à la couche électroactive dernièrement déposée n'est pas ou que peu transmise à la couche ou aux couches qui lui sont sous-jacentes. La couche supérieure peut ainsi être parfaitement cristallisée sans pour autant chauffer les couches sous-jacentes. Ces dernières ne subissent ainsi pas de multiples dilatations ce qui réduit l'apparition de fissures. En outre, l'état cristallin de toutes les couches sous-jacentes n'est pas ou que peu affecté par l'exposition UV de la couche supérieure. L'introduction d'une couche formant une barrière contre les UV permet ainsi d'améliorer la fiabilité et les performances du dispositif. Par ailleurs, ce type de composé a pour avantage de renforcer l'adhésion entre électrode et la couche électroactive à son contact.
- Avantageusement, la couche de blocage des UV bloque au moins 50% et de préférence au moins 70% et de préférence au moins 90% des UV traversant la couche électroactive supérieure et se dirigeant vers la couche électroactive inférieure.
- Avantageusement, la couche de blocage empêche tout passage des UV depuis la couche électroactive supérieure vers la couche électroactive inférieure.
- Préférentiellement, le composé non métallique absorbant ou bloquant les UV est un composé organique comportant une liaison thiol (-SH), également désignée groupement thiol (-SH). De préférence, les liaisons thiol sont prises par exemple parmi les produits suivants : Poly (éthylène glycol) methyl ether thiol, 2,5-dimethylfuran-3-thiol, 2-propène-1-thiol, 5-methoxybenzoxazole-2-thiol, 4-phenylimidazole-2-thiol, 4-phenylthiazole-2-thiol, 5-chloropyrine-2-thiol.
- Selon un exemple, le composé non métallique absorbant ou bloquant les UV est un composé organique comportant des groupements comme les aminés, silanes et aussi les molécules de pyrène.
- Avantageusement, la couche de blocage et l'électrode séparant la couche électroactive supérieure de la couche électroactive inférieure forment une même couche, ladite électrode comportant le composé non métallique absorbant ou bloquant les UV.
- Avantageusement, la couche de blocage est formée par l'électrode séparant la couche électroactive supérieure de la couche électroactive inférieure, dans lequel le composé non métallique absorbant ou bloquant les UV forme une liaison thiol (-SH) et dans lequel la concentration en liaisons thiol dans l'électrode est comprise entre 0.5 % à 10 % en poids et de préférence entre 1 % et 5 % en poids.
- Avantageusement, la formation de l'électrode comprend une étape de dépôt d'une solution métallique par jet d'encre, sérigraphie ou par pulvérisation par ultrasons, dans laquelle la formation de la couche de blocage comprend l'incorporation des liaisons thiol à la solution métallique, et dans lequel l'incorporation est effectuée en mélangeant les liaisons thiol à la solution métallique avant dépôt de la solution métallique.
- Avantageusement, la couche de blocage est une couche distincte de l'électrode séparant la couche électroactive supérieure de la couche électroactive inférieure, la couche de blocage étant située entre ladite électrode et l'une parmi la couche électroactive supérieure et la couche électroactive inférieure.
- Avantageusement, la formation de l'électrode comprend une étape de dépôt d'un métal par PVD, dans lequel la formation de la couche de blocage comprend l'incorporation des liaisons thiol au métal, et dans lequel l'incorporation est effectuée par trempage ou évaporation après le dépôt de métal.
- Avantageusement, il est aisé de contrôler les liaisons formées (R - S) avec R : le métal et S : le soufre. Ce contrôle s'effectue par exemple avec une analyse XPS (X-ray Photoelectron Spectrometry) qui consiste à envoyer des photons X avec la même énergie qui va servir à rompre ces liaisons. Le spectre final de caractérisation présente des pics qui renseignent sur la nature des liaisons chimiques.
- Avantageusement, l'empilement comporte plus de deux électrodes et seulement deux contacts électriques sont formés, soit par lithographie soit par sérigraphie, et sont configurés pour appliquer une différence de potentiel sur l'ensemble de l'empilement.
- Avantageusement, les électrodes sont des électrodes poreuses afin de diminuer les effets du module de Young et les effets de différence de contraintes entre la couche électroactive et l'électrode pour avoir le plus grand déplacement possible du dispositif.
- Avantageusement, l'empilement technologique peut être constitué de matériaux ayant un module de Young au moins égal à 200 MPa et de préférence compris entre 200 MPa et 5 GPa et de préférence entre 200 MPA et 2 GPa et, un coefficient de Poisson au moins égal à 0.30 et de préférence compris entre 0.30 et 0.39 de préférence entre 0.35 et 0.39 et avantageusement compris entre 0.38 et 0.39.
- De préférence, la couche électroactive est directement au contact des électrodes qui lui sont adjacentes. Selon un mode de réalisation comprenant une couche d'absorption des UV, la couche d'absorption des UV est directement au contact de l'électrode qui lui est adjacente et est de préférence directement au contact de la couche électroactive qui lui est adjacente.

Selon un autre mode de réalisation, l'invention porte sur un procédé de fabrication d'un actionneur électroactif à partir d'un empilement comprenant au moins une première électrode et au moins une couche électroactive comprenant un polymère électroactif surmontant la première électrode, la couche électroactive ayant la capacité de répondre par un déplacement et d'entrainer avec elle au moins la première électrode lorsqu'on lui applique un champ électrique, le procédé comprenant :
- une étape de cristallisation de la couche électroactive surmontant l'empilement ;
- une étape de formation d'une deuxième électrode de manière à ce que la couche électroactive soit disposée entre les deux électrodes.

Le polymère électroactif est formé d'un matériau apte à se cristalliser au moins en partie sous l'effet d'une d'exposition à un rayonnement ultra-violet (UV). Par ailleurs, l'étape de cristallisation comprend une étape d'exposition de la couche électroactive à un rayonnement ultra-violet. Avantageusement, l'étape d'exposition est une étape d'UV Flash également qualifiée de rayonnement UV à impulsions ultra brèves.

Selon un exemple, l'étape d'UV Flash comprend une exposition de la couche électroactive à un rayonnement ultra-violet pendant une durée inférieure ou égale à 1 seconde et de préférence inférieure ou égale à 500 millisecondes (10⁻³s) ou, selon un mode de réalisation, inférieure ou égale à 10 millisecondes.

Selon un mode de réalisation, l'étape d'exposition consiste uniquement en une étape d'UV Flash.

Toutes les caractéristiques mentionnées ci-dessus en rapport avec le mode de réalisation précédent sont combinables avec cet autre mode de réalisation. Notamment, l'étape d'UV Flash peut comprendre une seule ou plusieurs impulsions.

Selon encore un autre mode de réalisation, l'invention porte sur un actionneur électroactif comportant un empilement comprenant une pluralité de couches électroactives superposées, associées chacune à deux électrodes. Au moins certaines des couches électroactives comprennent un polymère électroactif apte à se cristalliser au moins en partie sous l'effet d'une exposition à un rayonnement ultra-violet. L'actionneur électroactif comporte, entre deux couches électroactives superposées, au moins une couche comportant un composé non métallique absorbant ou bloquant les UV.

L'utilisation d'au moins une couche comportant au moins un composé non métallique absorbant ou bloquant les UV est un mode de réalisation pouvant être réalisé indépendamment de l'utilisation de la technique d'UV Flash décrite précédemment.

L'utilisation de ce type de couche de blocage permet de réduire, voire d'empêcher, la propagation de la chaleur dans les couches de polymère électroactif inférieures et ainsi de solutionner la présente problématique.

Optionnellement et avantageusement, le composé non métallique absorbant ou bloquant les UV est un composé organique comportant une liaison thiol (-SH).

Selon un exemple, le dispositif comprend un ou plusieurs électroactionneurs selon l'invention.

Toutes les caractéristiques décrites précédemment, prises seules ou séparément, peuvent être combinées avec ce mode de réalisation.

Un autre objet de la présente invention concerne un dispositif microélectronique comprenant un ou plusieurs dispositifs haptiques ou électroactionneurs selon l'invention. Par dispositif microélectronique, on entend tout type de dispositif réalisé avec des moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...).

Un dispositif microélectronique peut ainsi par exemple être un appareil photo, un zoom pour appareil photo, un téléphone intelligent, un interrupteur mécanique, une tablette tactile.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les FIGURES 1, 2, 3, 4 et 5 représentent les différentes étapes technologiques d'un exemple de réalisation d'actionneurs électroactifs basés sur cette invention.
Les FIGURES 6 et 7a et 7b représentent des études comparatives de la cristallisation du film de P(VDF-TrFe-CTFE) entre un recuit standard et une cristallisation par UV Flash.
La FIGURE 8a représente le déplacement d'un actionneur à base de P(VDF-TrFe-CTFE) réalisé par la présente technique suivant la verticale (z) en fonction de la tension appliquée sur deux de ses côtés, et en fonction du champ électrique pour la FIGURE 8b. Enfin la FIGURE 8c montre la déformation en pourcentage du dispositif en fonction du champ électrique appliqué suivant la verticale z à laquelle correspond l'épaisseur du dispositif.
La FIGURE 9 représente un exemple de schéma de connexion des électrodes pour la formation de capacités en minimisant le nombre de connexion.
Les FIGURES 10a et 10b représentent un schéma de la conception de trois actionneurs électroactifs 10a et une photographie optique 10b de ces trois actionneurs une fois réalisés.

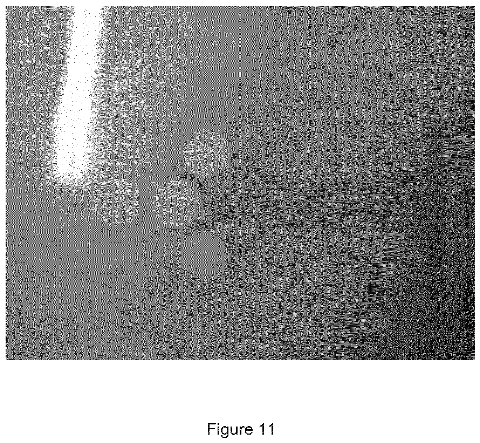

La FIGURE 11 représente une image optique d'un motif d'actionneur cylindrique. C'est un dispositif electroactif (Métal/polymère/métal) de forme cylindrique avec un diamètre de 7 mm déposé sur 125 µm de PEN.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des différentes couches et films ne sont pas représentatives de la réalité.

### DESCRIPTION DÉTAILLÉE DE L'INVENTION

Il est précisé que dans le cadre de la présente invention, le terme « sur », « surmonte », « recouvre » ou « sous-jacent » ou leurs équivalents ne signifient pas « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par au moins une autre couche ou au moins un autre élément.

Dans la présente demande de brevet, l'épaisseur est prise selon une direction perpendiculaire aux faces principales du substrat sur lequel repose les différentes couches. Sur les figures, l'épaisseur est prise selon la verticale.

Dans le cadre de la présente invention, on désigne par matériau électroactif un matériau ayant la capacité de répondre par un déplacement lorsqu'on lui applique un champ électrique.

Dans le cadre de la présente invention, on désigne par UV Flash, une exposition à, entre autre, un rayonnement ultraviolet (longueur d'onde comprise entre 200 nm et 800 nm) comportant une ou plusieurs impulsions. Chaque impulsion étant inférieure à 100 ms. Dans le cas d'une exposition à plusieurs impulsions, les impulsions sont espacées dans le temps afin de permettre à la couche exposée de refroidir et d'éviter ainsi que la chaleur ne se propage aux couches sous-jacentes.

L'invention présentée ici consiste en un procédé de fabrication d'actionneurs électroactifs pouvant travailler à basse tension, réduisant les risques de fissurations, d'introduction de capacitance parasite et de dégradation dans le temps liée à l'humidité.

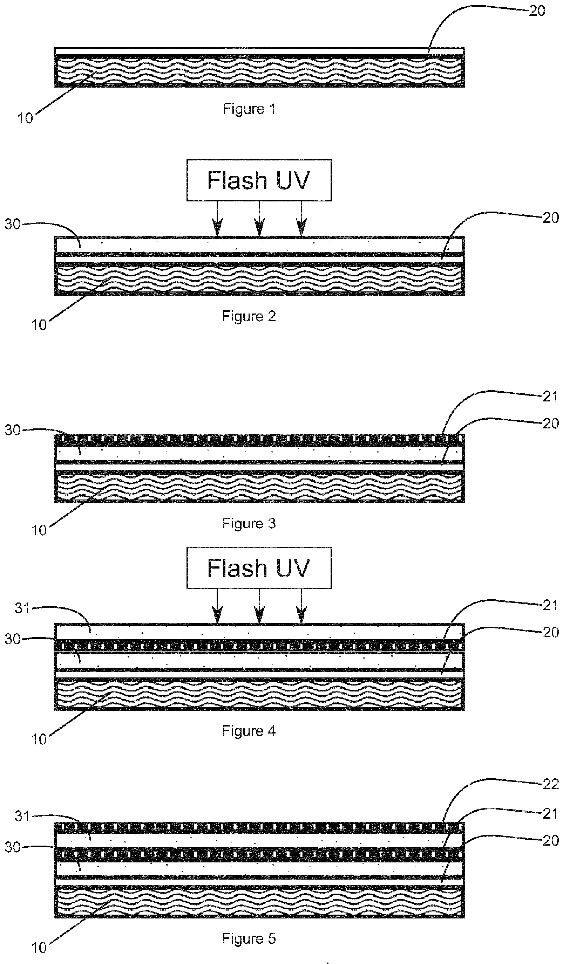

Un exemple de procédé selon l'invention pour la réalisation d'un actionneur électroactif est décrit ci-dessous en référence aux figures 1 à 5.

La première étape, présentée par la FIGURE 1, consiste à déposer une couche métallique 20 sur un substrat flexible 10. Ce dernier est par exemple en PEN, PET, Kapton ou Peek. Son épaisseur peut être comprise entre 5 µm et 300 µm et de préférence entre 5 µm et 200 µm et de préférence entre 5 µm et 50 µm

Le matériau utilisé pour l'électrode 20 est de préférence en métal. Elle peut par exemple comprendre ou être constituée d'or (Au), d'argent (Ag), de platine (Pt), d'aluminium (Al), de nickel (Ni), de palladium (Pd), de cuivre (Cu) ou d'oxyde d'indium-étain (ITO). L'épaisseur de cette couche métallique 20 peut être comprise entre 10 nm et 8 µm et de préférence entre 10 nm et 1 µm

Le dépôt de cette couche métallique 20 peut être réalisé par diverses techniques comme par exemple un dépôt physique en phase vapeur (PVD), par jet d'encre, par sérigraphie ou par pulvérisation par ultrasons.

Le recours ici à une encre d'argent en nanofils déposée par sérigraphie, jet d'encre ou pulvérisation par ultrasons, par exemple, permet d'obtenir une couche transparente et une plus grande flexibilité mécanique des actionneurs. Cette propriété de transparence peut être utilisée pour certaines applications comme dans des tablettes tactiles, par exemple pour générer des retours de vibrations sur les tablettes.

Alternativement l'électrode 20 peut être réalisée en graphène qui peut être déposé en solution, le graphène est transparent, conducteur et économiquement avantageux.

La seconde étape, présentée par la FIGURE 2, comprend la formation d'une couche électroactive 30 sur l'électrode 20 formée à l'étape précédente, qualifiée d'électrode inférieure.

Cette étape comprend le dépôt de P(VDF-TrFe-CFE) ou de P(VDF-TrFe-CTFE) en solution dans un solvant comme le cyclopentanone par exemple. Le dépôt sur l'empilement se fait par exemple par spin coating (à la tournette), jet d'encre, sérigraphie, ou pulvérisation par ultrasons. Selon un mode de réalisation, l'épaisseur de la couche électroactive 30 est comprise entre 100 nm et 10 µm et de préférence entre 100 nm et 4 µm.Une fois déposée, la couche de polymère 30 doit être rendue cristalline, totalement ou du moins en partie. Pour cela, l'invention prévoit d'effectuer une cristallisation par UV Flash, également appelée recuit UV avec impulsions, ces impulsions étant inférieures à 100 millisecondes.

La durée de l'impulsion UV Flash (aux ultra-violets (UV)) est comprise avantageusement entre 0.5 ms et 3 ms et de préférence entre 1 ms et 2 ms. Cette cristallisation par UV Flash utilise une fluence variant entre 5 j/cm² et 30 j/cm² et de préférence entre 15 j/cm² et 20 j/cm². De préférence, pour une couche de polymère de 2 µm, on applique un flux de 17 j/cm² à une distance de 7 cm entre le substrat et la lampe UV flash

Ce mode de cristallisation par UV Flash est très rapide, simple et fiable. Cette étape peut remplacer alors le recuit thermique dit standard qui est de 115°C pendant 30 à 60 minutes. Un recuit est nécessaire pour la cristallisation du polymère électroactif. Cependant des recuits thermiques standards successifs d'une même couche détériorent sa cristallinité, diminuant de ce fait ses propriétés électroactives. La présente technique permet d'éviter ces inconvénients. L'utilisation de la technique de cristallisation par UV Flash permet de diminuer l'effet de dégradation et de fissuration sur les couches précédemment recuites, son action étant superficielle.

L'étape suivante, représentée par la FIGURE 3, comprend la formation d'une électrode supérieure 21 pour la couche électroactive 30 formée à l'étape précédente.

Dans le cas où l'électrode 21 est en métal, cette étape comprend le dépôt d'une couche métallique d'Au, Al, Pt, Ag, Cu, Ni, Pd ou ITO par exemple, par PVD, par impression en solution, par jet d'encre, par sérigraphie ou par pulvérisation par ultrasons, par exemple.

L'épaisseur déposée est comprise entre 10 nm et 8 µm et de préférence entre 10 nm et 1 µm. Selon un mode de réalisation optionnelle et très avantageux, on réalise une couche de blocage des UV. Cette couche a pour fonction d'absorber ou bloquer une partie au moins des UV parvenant sur une première face de cette couche de blocage et de limiter ainsi le flux d'UV transmis à une couche au contact d'une deuxième face de la couche de blocage opposée à la première face. Cette couche forme ainsi une barrière contre les UV.

Elle permet de réduire la possibilité que le flux d'UV apporté à une couche électroactive supérieure 31, par exemple dont une face est disposée à l'air libre, ne parvienne à une couche électroactive inférieure disposée en aval de la couche électroactive supérieure par rapport au flux d'UV.

Ainsi, la couche électroactive inférieure 30 n'est pas ou que peu impactée par le flux d'UV apporté à la couche électroactive supérieure 31 pour cristalliser cette dernière, et ce, même si les épaisseurs des différentes couches sont faibles ou que la puissance du flux d'UV est élevée. Par conséquent, la couche électroactive inférieure 30 n'est pas ou que peu dégradée.

Les risques d'apparition de fissures ou de dégradation de l'état cristallin des couches électroactives superposée sont donc réduits, quand bien même les épaisseurs des différentes couches sont faibles ou la puissance du flux d'UV élevée.

Ce mode de réalisation de l'invention permet ainsi de renforcer la fiabilité du procédé et de l'actionneur électroactif obtenu tout en conservant un procédé rapide et simple.

Cette couche de blocage peut soit être incorporée au sein de l'électrode 21 soit être située entre l'électrode 21 et la couche électroactive 31, par exemple, en étant formée sur une face de l'électrode 21.

Selon un exemple, la couche de blocage des UV comporte au moins un composé non métallique absorbant ou bloquant les UV.

Selon un mode de réalisation, ce composé comporte une liaison thiol (-SH), également désigné groupement thiol (-SH).

Des liaisons -SH (thiol) sont incorporées de différentes manières en fonction de la technique de dépôt du film métallique 21 utilisée. Ces liaisons -SH sont contenues dans des produits comme par exemple : Poly(éthylène glycol) methyl ether thiol, 2,5-dimethylfuran-3-thiol, 2-propène-1-thiol, 5-methoxybenzoxazole-2-thiol, 4-phenylimidazole-2-thiol, 4-phenylthiazole-2-thiol, 5-chloropyrine-2-thiol par exemple.

Avantageusement, les liaisons thiol permettent de former des liaisons covalentes avec le métal lorsqu'elles absorbent des UV. Cela permet de renforcer la cohésion de l'empilement ce qui est avantageux lorsque les liaisons thiol sont déposées à l'interface électrode/couche électroactive. Elles permettent de protéger des UV les couches de polymères inférieures.

La concentration de ces liaisons thiol est comprise de préférence entre 0.5 % à 10 % en poids et de préférence entre 1 % et 5 % en poids. Cette molécule est isolante électriquement, tout ce qui n'est pas greffé (qui n'a pas formé de liaison covalente) est une source de capacité parasite, d'où la nécessité d'adapter la concentration à la matière métallique présente. L'objectif est de greffer la totalité des molécules sans la phase isolante entre les particules métalliques (sans agglomérat de molécules non greffées)

Si le métal est déposé par PVD (dépôt physique en phase vapeur) ou en solution par jet d'encre, sérigraphie, alors ces liaisons thiol sont de préférence déposées par trempage ou par évaporation par exemple et ce après le dépôt du métal. Si le métal est déposé en solution par sérigraphie, jet d'encre ou par pulvérisation par ultrasons par exemple, alors ces liaisons sont de préférence ajoutées et mélangées dans la solution du métal à déposer.

L'étape suivante, illustrée en FIGURE 4, comprend la formation d'une couche électroactive additionnelle 31. Cette étape comprend par exemple le dépôt de P(VDF-TrFe-CFE) ou de P(VDF-TrFe-CTFE) en solution par tournette (spin coating), jet d'encre, sérigraphie ou par pulvérisation par ultrasons par exemple. Son épaisseur est comprise entre 100 nm et 10 µm et de préférence entre 100 nm et 4 µm.

Ce dépôt est alors suivi d'une cristallisation par UV Flash avec une impulsion d'une durée variant entre 0.5 ms et 3 ms et de préférence entre 1 ms et 2 ms et pour une fluence variant entre 10 j/cm² et 30 j/cm² et de préférence entre 15 j/cm² et 20 j/cm². Cette étape permet la cristallisation de cette couche électroactive 31 dernièrement déposée.

Cette couche électroactive supérieure 31 surmonte la couche d'absorption des UV, cette dernière étant disposée sur ou intégrée à l'électrode 21 déjà formée et située sous la couche électroactive supérieure 31. La présence du composé fortement absorbant dans le spectre UV, typiquement les liaisons thiol, permet une protection des couches sous-jacentes. Dans l'exemple illustré, limité à deux couches seulement, la couche électroactive 30 ne reçoit pas ou que peu d'UV lors de l'exposition servant à cristalliser la couche électroactive 31. On évite ainsi la fissuration de celles-ci et la dégradation de leur structure cristalline.

L'étape suivante, représentée par la FIGURE 5, représente la réalisation d'une électrode 22 additionnelle, permettant de former, avec l'électrode 21 et la couche électroactive 31 une capacité. Cette étape comprend le dépôt d'une couche métallique 22 d'Au, Al, Pt, Ag, Cu, Ni, Pd ou ITO par exemple. Comme indiqué précédemment, cette étape peut être effectuée par PVD, par impression en solution, par jet d'encre, par sérigraphie ou par pulvérisation par ultrasons par exemple.

L'épaisseur déposée est comprise entre 10 nm et 8 µm et de préférence entre 10 nm et 1 µm.

Avantageusement on associe à l'électrode 22 une couche additionnelle d'absorption des UV. Cette couche d'absorption est soit intégrée au sein de l'électrode 22 soit apposée à cette dernière. Typiquement, pour former cette couche d'absorption on utilisera à nouveau des liaisons -SH (thiol).

Leur incorporation peut être effectuée de différentes manières en fonction de la technique de dépôt du film métallique utilisée. Si le métal est déposé par PVD, alors ces liaisons thiol sont de préférence déposées par trempage ou par évaporation par exemple et ce après le dépôt du métal. Si le métal est déposé en solution par sérigraphie, jet d'encre ou par pulvérisation par ultrasons par exemple, alors ces liaisons sont de préférence ajoutées et mélangées dans la solution du métal à déposer.

Dans l'exemple illustré, l'empilement représenté ne comprend que deux couches électroactivables et trois électrodes. On comprend aisément qu'en reproduisant les étapes précédentes, on peut obtenir un empilement avec n couches électroactivables et n+1 électrodes. L'invention permet d'obtenir sans difficulté des électroactionneurs fiables et performants présentant plus de 5 à 10 couches électroactivables.

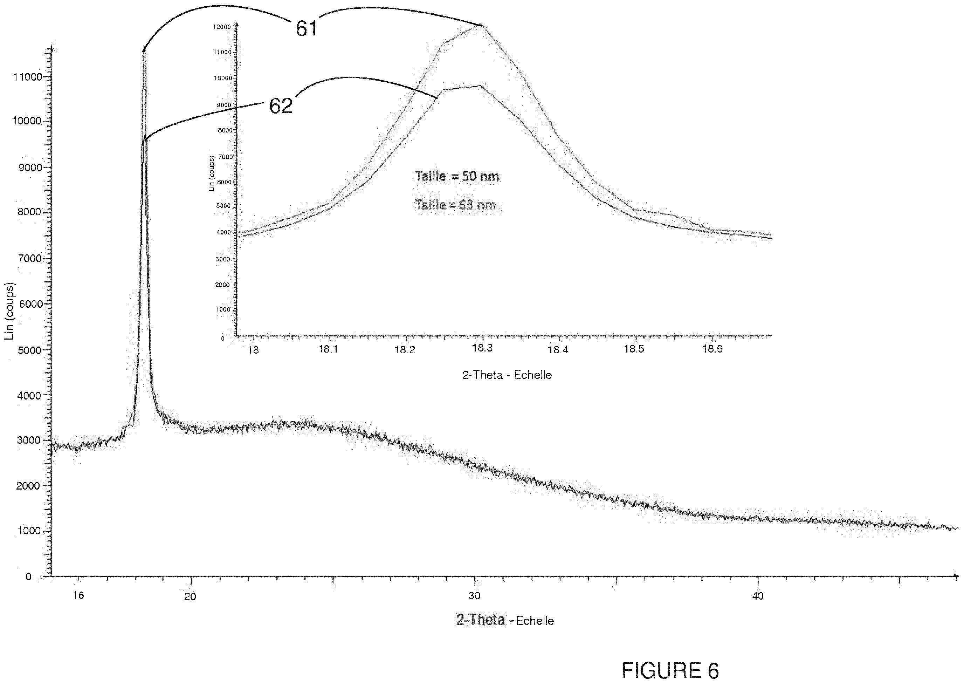

Enfin, cette technique de cristallisation par UV Flash est très rapide et très simple. Elle assure une cristallisation similaire à un recuit thermique standard. Cela est illustré par la FIGURE 6 qui compare le diagramme 61 de diffraction X d'un recuit standard et le diagramme 62 d'un recuit UV Flash.

Le diagramme 61 est obtenu par analyse d'une couche de 2µm d'épaisseur de P(VDF-TrFe-CTFE) recuite avec un recuit conventionnel à 115°C pendant 30 minutes. Le diagramme 62 est obtenu par analyse d'une couche de 2 µm d'épaisseur de P(VDF-TrFe-CTFE) recuite par UV flash avec une durée d'impulsion de 2 ms avec un nombre de flash (ou impulsions) de 5 et une fluence de 17.5 j/cm².

Cette expérience montre clairement que la cristallisation est identique entre les deux techniques avec une très faible variation de la taille des cristallites.

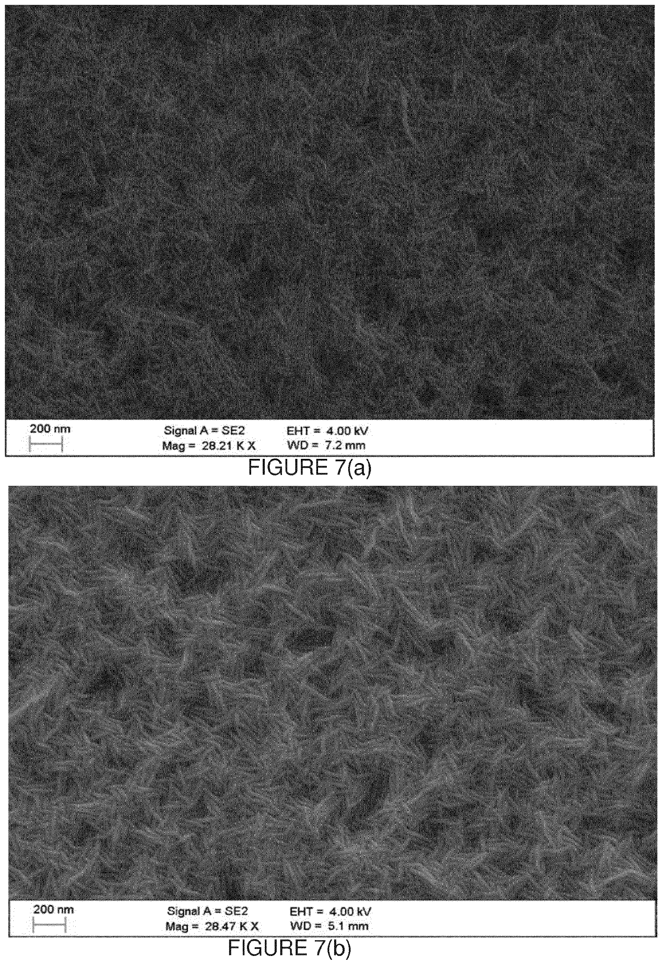

De plus, les FIGURES 7a et 7b illustrent en microscopie électronique à balayage la structure cristalline d'un échantillon recuit par UV Flash pour la FIGURE 7a et par recuit thermique standard pour la FIGURE 7b. Les structures observées sont sensiblement identiques.

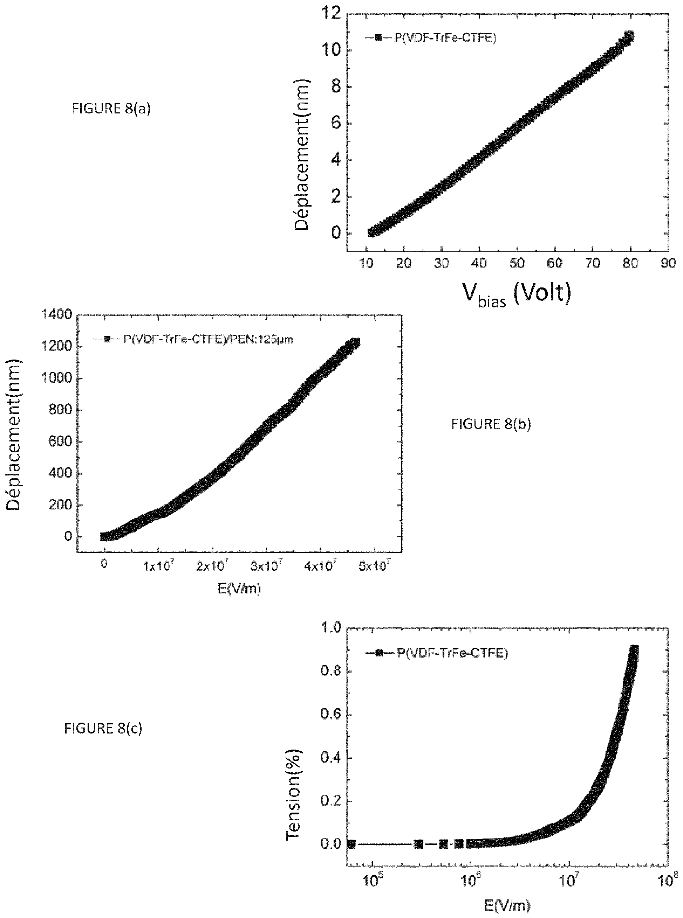

Les FIGURES 8a et 8b représentent des mesures du déplacement suivant z (direction verticale) au plan des actionneurs en fonction de la tension et du champ électrique E grâce à un vibromètre laser, ainsi que la mesure de la contrainte appliquée sur le dispositif en fonction du champ électrique (FIGURE 8c). Une tension est appliquée sur les côtés d'un actionneur libre. Cette tension provoque une contrainte sur le matériau électroactif. Une mesure du déplacement de l'actionneur suivant la direction z, par exemple, est alors réalisée. La FIGURE 8a représente ces mesures. Ensuite la FIGURE 8b représente ce même déplacement mais en fonction du champ électrique. Dans ce mode de réalisation et pour cette expérience, le substrat est un substrat en PEN d'une épaisseur de 125 µm.

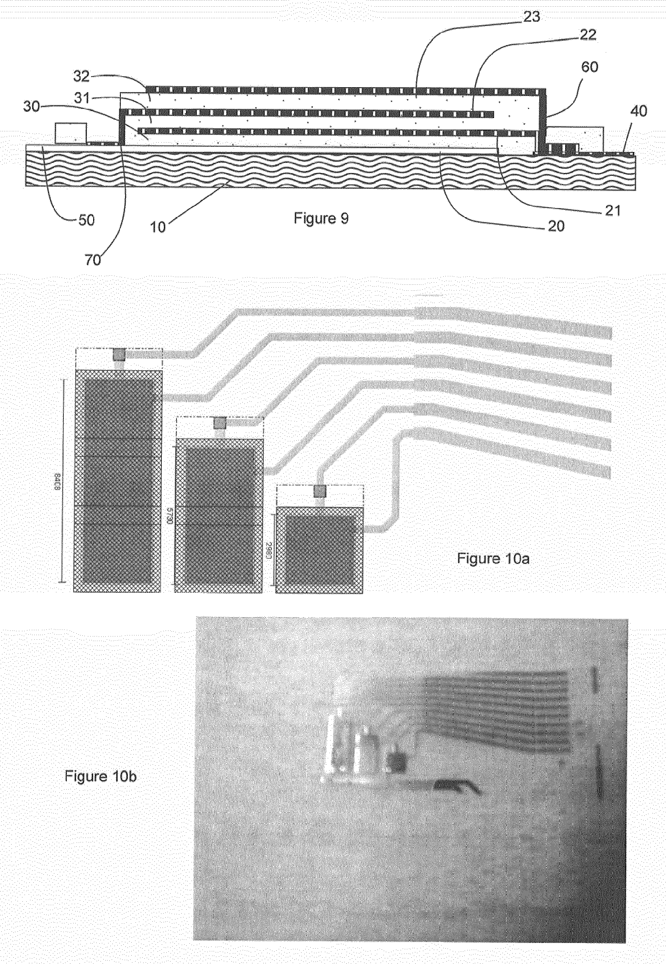

Un mode de réalisation de cet actionneur est présenté sur les FIGURES 10a et 10b : la FIGURE 10a étant un schéma de trois actionneurs et la FIGURE 10b étant une photographie du dispositif ainsi réalisé. A partir des courbes figurant dans les FIGURES 8a, 8b et 8c, il est possible d'extraire la valeur du champ électrique nécessaire pour une déformation de 1 % et qui est de 50 MV/m. Il résulte de ces études que pour avoir un plus grand déplacement, l'épaisseur du substrat doit être diminuée jusque 8 µm par exemple non limitatif. L'utilisation de matériaux dans l'empilement technologique avec un module de Young de préférence compris entre 200 MPa et 5 GPa et de préférence entre 200 MPA et 2 GPa, et un coefficient de Poisson de préférence compris entre 0.30 et 0.39 de préférence entre 0.35 et 0.39 et avantageusement entre 0.38 et 0.39, peut également permettre d'atteindre un déplacement plus conséquent pour un champ électrique équivalent.

Enfin, la modification de la nature des électrodes peut permettre une diminution de la valeur du champ électrique nécessaire pour atteindre 3 % de déformation.

Suivant un mode de réalisation avantageux, on utilise des électrodes poreuses. Ce qui permet de diminuer les effets du module de Young afin d'avoir des forts déplacements et pour diminuer les différences de contraintes entre les couches de l'empilement.

La FIGURE 9 illustre un mode de réalisation dans lequel avantageusement le nombre de connexions électriques nécessaires au fonctionnement du dispositif est réduit. Selon ce mode de réalisation, un actionneur électroactif est composé d'un empilement de n couches électroactives et de (n+1) couches d'électrodes. La fabrication de ce dispositif se fait en superposant une couche métallique et une couche de polymère électroactif en ouvrant à chaque fois un trou, également appelé via, dans cette couche de polymère, ce trou débouche à chaque fois en alternant sur le niveau métallique.

Une première électrode 20 est déposée sur une fraction de la surface d'un substrat 10. Puis une couche électroactive 30 est déposée sur une fraction de la surface de l'électrode 20. Une cristallisation de la couche électroactive 30 par UV Flash est alors effectuée. Puis une seconde électrode 21 est déposée sur la couche électroactive de manière à ne pas rentrer en contact électrique avec la précédente électrode 20. Ensuite, de nouveau, une couche électroactive 31 est déposée sur la surface de l'électrode 21. Cette couche électroactive 31 est en contact avec la couche électroactive 30. Une étape de cristallisation de la couche électroactive 31 est alors effectuée par UV Flash. De nouveau une électrode 22 est déposée sur une fraction de la surface de la couche électroactive 31 de sorte que l'électrode 22 soit en contact électrique avec l'électrode 20 et qu'elle ne soit pas en contact électrique avec l'électrode 21. Puis une troisième couche électroactive 32 est déposée sur la surface de l'électrode 22. La couche électroactive 32 est en contact avec la couche électroactive 31. La couche électroactive 32 subit alors une cristallisation par UV Flash. Une dernière électrode 23 est alors déposée sur une fraction de la surface de la couche électroactive 32 de sorte que l'électrode 23 soit en contact électrique avec l'électrode 21 et qu'elle ne soit pas en contact électrique avec les électrodes 20 et 22. En finalité, les électrodes 20 et 22 sont en contact électriques par la partie conductrice 70, et les électrodes 21 et 23 sont en contact électrique par la partie conductrice 60. Enfin, la connexion 50 est électriquement en contact avec la partie 70 et la connexion 40 est électriquement en contact avec la partie 60, de sorte que l'application d'une différence de potentiel entre les connexions 50 et 40 suffit à activer simultanément les couches électroactives 30, 31 et 32.

Selon ce mode de réalisation, toutes les électrodes impaires possèdent une connexion électrique commune avec la première électrode déposée et toutes les électrodes paires possèdent une connexion électrique commune avec la seconde électrode déposée. Les termes « paire » et « impaire » faisant référence à l'ordre de dépôt des électrodes entre elles, la première électrode ayant le nombre « un » attribué, donc impaire, et la seconde électrode ayant le nombre « deux » attribué, donc paire.

Il est possible de continuer ce mode de réalisation pour obtenir un dispositif plus épais, toutefois la caractéristique principale de ce mode de réalisation repose sur l'utilisation de seulement deux contacts électriques pour appliquer une différence de potentiel sur l'ensemble des couches électroactives. Ce mode de réalisation permet une diminution de la tension électrique appliquée au dispositif total, il permet aussi d'avoir d'important déplacement du dispositif.

Il ressort clairement de la description qui précède que l'invention permet d'obtenir un empilement de n couches de polymères électroactifs cristallisées (comme illustré par la FIGURE 5) et de n+1 électrodes sans fissurations, grâce à l'action superficielle du recuit UV Flash et optionnellement grâce à la protection des couches inférieures réalisée par les liaisons thiol.

L'invention n'est pas limitée aux modes de réalisations précédemment décrits et s'étend à tous les modes de réalisation couverts par les revendications.

## Revendications

1. Procédé de fabrication d'un actionneur électroactif à partir d'un empilement comprenant au moins une première électrode (20) et au moins une couche comprenant un polymère électroactif surmontant l'électrode (20), le polymère électroactif ayant la capacité de répondre par un déplacement lorsqu'il est dans un état cristallin et qu'on lui applique un champ électrique, le procédé comprenant :
- une étape d'obtention d'une couche électroactive (30) comprenant une étape de cristallisation de la couche comprenant le polymère électroactif surmontant l'empilement ;
- une étape de formation d'une deuxième électrode (21) de manière à ce que la couche électroactive (30) soit disposée entre les deux électrodes (20, 21) ;
**caractérisé en ce que** le polymère électroactif est formé d'un matériau apte à se cristalliser au moins en partie sous l'effet d'une d'exposition à un rayonnement ultra-violet (UV) et **en ce que** l'étape de cristallisation comprend une étape d'exposition de la couche électroactive (30) à un rayonnement ultra-violet au cours de laquelle une partie au moins du rayonnement ultra-violet est délivré sous forme d'une ou plusieurs impulsions, la durée de chaque impulsion étant inférieure à 100 millisecondes (ms) (10 ⁻³ secondes) et dans lequel à partir de l'empilement comprenant au moins une couche comprenant un polymère électroactif disposé entre deux électrodes (20, 21), on effectue la séquence d'étapes suivantes :
- formation d'une couche additionnelle de polymère électroactif surmontant ledit empilement ;
- obtention d'une couche électroactive additionnelle (31) par cristallisation de ladite couche additionnelle de polymère électroactif, la cristallisation comprenant une étape d'exposition de la couche additionnelle de polymère électroactif à un rayonnement UV, l'étape d'exposition comprenant la ou les impulsions;
- formation d'une électrode (22) surmontant ladite couche électroactive additionnelle (31).

2. Procédé selon la revendication précédente dans lequel on réitère ladite séquence d'étapes de manière à obtenir un empilement d'une pluralité de couches électroactives (30, 31) ayant chacune fait l'objet d'une étape indépendante d'exposition de la couche électroactive (30) à un rayonnement ultra-violet et chacune située entre deux électrodes (20, 21, 22).

3. Procédé selon la revendication précédente dans lequel la pluralité de couches électroactives comporte au moins trois couches électroactives et de préférence au moins cinq couches électroactives.

4. Procédé selon l'une quelconque des revendications précédentes dans lequel la durée de chaque impulsion est inférieure à 10 ms et de préférence inférieure à 3 ms, et dans lequel la durée d'exposition est comprise entre 0.5 ms et 3 ms et de préférence entre 0.5 ms et 2 ms, et dans lequel au cours de l'étape d'exposition le rayonnement ultra-violet est délivré sous forme d'une ou plusieurs impulsions, la fluence de chacune des impulsions étant inférieure à 50 j/cm² et de préférence étant comprise entre 2 j/cm² et 40 j/cm² et de préférence entre 5 j/cm² et 30 j/cm² et de préférence entre 15 j/cm² et 20j/cm².

5. Procédé selon l'une quelconque des revendications précédentes dans lequel l'étape de cristallisation comprend uniquement ladite étape d'exposition, et dans lequel la couche électroactive (30) est de préférence uniquement constituée du polymère électroactif.

6. Procédé selon l'une quelconque des revendications précédentes dans lequel l'empilement repose sur un substrat (10) suffisamment flexible pour suivre le déplacement de l'empilement.

7. Procédé selon l'une quelconque des revendications précédentes dans lequel l'empilement comprend plusieurs couches électroactives (30, 31) et dans lequel après cristallisation d'une couche électroactive inférieure (30) et avant la formation d'une deuxième couche électroactive supérieure (31) surmontant la couche électroactive inférieure (30), on réalise une couche de blocage des UV disposée entre les couches électroactives inférieures et supérieures, ladite couche de blocage comportant au moins un composé non métallique absorbant ou bloquant les UV, de manière à ce que la couche de blocage des UV bloque une partie au moins des UV traversant la couche électroactive supérieure et se dirigeant vers la couche électroactive inférieure, et dans lequel la couche de blocage des UV bloque au moins 50% et de préférence au moins 70% et de préférence au moins 90% des UV traversant la couche électroactive supérieure et se dirigeant vers la couche électroactive inférieure.

8. Procédé selon la revendication précédente dans lequel le composé non métallique absorbant ou bloquant les UV est un composé organique comportant une liaison thiol (-SH).

9. Procédé selon la revendication précédente, dans lequel la couche de blocage est formée par l'électrode (21) séparant la couche électroactive supérieure (31) de la couche électroactive inférieure (30), dans lequel le composé non métallique absorbant ou bloquant les UV forme de préférence une liaison thiol (-SH) et dans lequel la concentration en liaisons thiol dans l'électrode (21) est de préférence comprise entre 0.5 % à 10 % en poids et de préférence entre 1 % et 5 % en poids.

10. Procédé selon l'une quelconque des trois revendications précédentes dans lequel la couche de blocage et l'électrode (21) séparant la couche électroactive supérieure (31) de la couche électroactive inférieure (30) forment une même couche, ladite électrode comportant le composé non métallique absorbant ou bloquant les UV.

11. Procédé selon l'une quelconque des quatre revendications précédentes dans lequel la formation de l'électrode (21) comprend une étape de dépôt d'une solution métallique par jet d'encre, sérigraphie ou par pulvérisation par ultrasons, dans lequel la formation de la couche de blocage comprend l'incorporation des liaisons thiol à la solution métallique, et dans lequel l'incorporation est effectuée en mélangeant les liaisons thiol à la solution métallique avant dépôt de la solution métallique.

12. Procédé selon l'une quelconque des revendications 7 à 9 dans lequel la couche de blocage est une couche distincte de l'électrode (21) séparant la couche électroactive supérieure (31) de la couche électroactive inférieure (30), la couche de blocage étant située entre ladite électrode (21) et l'une parmi la couche électroactive supérieure (31) et la couche électroactive inférieure (30).

13. Procédé selon l'une quelconque des revendications précédentes dans lequel l'empilement comporte plus de deux électrodes (20, 21, 22) et dans lequel on forme deux contacts électriques seulement, configurés pour appliquer une différence de potentiel sur l'ensemble de l'empilement.

14. Electroactionneur comportant un empilement comprenant une pluralité de couches électroactives superposées, associées chacune à deux électrodes, **caractérisé en ce que** au moins certaines des couches électroactives comprend un polymère électroactif apte à se cristalliser au moins en partie sous l'effet d'une exposition à un rayonnement ultra-violet et **en ce qu'**il comporte, entre deux couches électroactives superposées, au moins une couche comportant au moins un composé non métallique absorbant ou bloquant les UV.

15. Dispositif comprenant un ou plusieurs électroactionneurs selon l'une quelconque des deux revendications précédentes.

## Patentansprüche

1. Verfahren zur Herstellung eines elektroaktiven Aktuators ausgehend von einem Stapel, der mindestens eine erste Elektrode (20) und mindestens eine die Elektrode (20) überdeckende Schicht umfasst, die ein elektroaktives Polymer umfasst, wobei das elektroaktive Polymer die Fähigkeit aufweist, mit einer Bewegung zu reagieren, wenn es sich in einem kristallinen Zustand befindet und ein elektrisches Feld an es angelegt wird, wobei das Verfahren umfasst:
- einen Schritt des Erhaltens einer elektroaktiven Schicht (30), der einen Schritt des Kristallisierens der den Stapel überdeckenden Schicht umfasst, die das elektroaktive Polymer umfasst;
- einen Schritt des Bildens einer zweiten Elektrode (21) so, dass die elektroaktive Schicht (30) zwischen den zwei Elektroden (20, 21) angeordnet ist;
**dadurch gekennzeichnet, dass** das elektroaktive Polymer aus einem Material gebildet ist, das unter der Wirkung einer Exposition gegenüber einer ultravioletten (UV-) Strahlung mindestens zum Teil kristallisieren kann, und dadurch, dass der Kristallisierschritt einen Schritt des Exponierens der elektroaktiven Schicht (30) gegenüber einer ultravioletten Strahlung umfasst, in dessen Verlauf mindestens ein Teil der ultravioletten Strahlung in Form von einem oder mehreren Impulsen abgegeben wird, wobei die Dauer jedes Impulses kleiner als 100 Millisekunden (ms) (10⁻³ Sekunden) ist, und wobei ausgehend von dem Stapel, der mindestens eine zwischen zwei Elektroden (20, 21) angeordnete, ein elektroaktives Polymer umfassende Schicht umfasst, die folgende Schrittfolge durchgeführt wird:
- Bilden einer zusätzlichen Schicht aus elektroaktivem Polymer, die den Stapel überdeckt;
- Erhalten einer zusätzlichen elektroaktiven Schicht (31) durch Kristallisieren der zusätzlichen Schicht aus elektroaktivem Polymer, wobei das Kristallisieren einen Schritt des Exponierens der zusätzlichen Schicht aus elektroaktivem Polymer gegenüber einer UV-Strahlung umfasst, wobei der Exponierschritt den oder die Impulse umfasst;
- Bilden einer Elektrode (22), die die zusätzliche elektroaktive Schicht (31) überdeckt.

2. Verfahren nach dem vorstehenden Anspruch, wobei die Schrittfolge wiederholt wird, um einen Stapel aus einer Vielzahl von elektroaktiven Schichten (30, 31) zu erhalten, die jede Gegenstand eines unabhängigen Schritts des Exponierens der elektroaktiven Schicht (30) gegenüber einer ultravioletten Strahlung waren und jede zwischen zwei Elektroden (20, 21, 22) liegen.

3. Verfahren nach dem vorstehenden Anspruch, wobei die Vielzahl von elektroaktiven Schichten mindestens drei elektroaktive Schichten, und vorzugsweise mindestens fünf elektroaktive Schichten umfasst.

4. Verfahren nach einem der vorstehenden Ansprüche, wobei die Dauer jedes Impulses kleiner als 10 ms, und vorzugsweise kleiner als 3 ms ist, und wobei die Expositionsdauer im Bereich zwischen 0,5 ms und 3 ms, und vorzugsweise zwischen 0,5 ms und 2 ms liegt, und wobei im Laufe des Exponierschritts die ultraviolette Strahlung in Form von einem oder mehreren Impulsen abgegeben wird, wobei die Fluenz jedes der Impulse kleiner als 50 j/cm² ist und vorzugsweise im Bereich zwischen 2 j/cm² und 40 j/cm² und vorzugsweise zwischen 5 j/cm² und 30 j/cm² und vorzugsweise zwischen 15 j/cm² und 20 j/cm² liegt.

5. Verfahren nach einem der vorstehenden Ansprüche, wobei der Kristallisierschritt ausschließlich den Exponierschritt umfasst, und wobei die elektroaktive Schicht (30) vorzugsweise ausschließlich aus dem elektroaktiven Material besteht.

6. Verfahren nach einem der vorstehenden Ansprüche, wobei der Stapel auf einem Substrat (10) ruht, das ausreichend flexibel ist, um der Bewegung des Stapels zu folgen.

7. Verfahren nach einem der vorstehenden Ansprüche, wobei der Stapel mehrere elektroaktive Schichten (30, 31) umfasst, und wobei nach dem Kristallisieren einer unteren elektroaktiven Schicht (30) und vor dem Bilden einer zweiten oberen elektroaktiven Schicht (31), die die untere elektroaktive Schicht (30) überdeckt, eine Schicht zum Sperren der UV-Strahlen ausgeführt wird, die zwischen der unteren und oberen elektroaktiven Schicht angeordnet ist, wobei die Sperrschicht mindestens eine nichtmetallische Verbindung umfasst, die die UV-Strahlen absorbiert oder sperrt, sodass die Schicht zum Sperren der UV-Strahlen mindestens einen Teil der UV-Strahlen sperrt, die die obere elektroaktive Schicht durchdringen und auf die untere elektroaktive Schicht zusteuern, und wobei die Schicht zum Sperren der UV-Strahlen mindestens 50 % und vorzugsweise mindestens 70 % und vorzugsweise mindestens 90 % der UV-Strahlen sperrt, die die obere elektroaktive Schicht durchdringen und auf die untere elektroaktive Schicht zusteuern.

8. Verfahren nach dem vorstehenden Anspruch, wobei die nichtmetallische Verbindung, die die UV-Strahlen absorbiert oder sperrt, eine organische Verbindung ist, die eine Thiolbindung (-SH) umfasst.

9. Verfahren nach dem vorstehenden Anspruch, wobei die Sperrschicht von der Elektrode (21) gebildet wird, die die obere elektroaktive Schicht (31) von der unteren elektroaktiven Schicht (30) trennt, wobei die nichtmetallische Verbindung, die die UV-Strahlen absorbiert oder sperrt, vorzugsweise eine Thiolbindung (-SH) bildet, und wobei die Konzentration an Thiolbindungen in der Elektrode (21) vorzugsweise im Bereich zwischen 0,5 Gewichts-% bis 10 Gewichts-%, und vorzugsweise zwischen 1 Gewichts-% und 5 Gewichts-% liegt.

10. Verfahren nach einem der drei vorstehenden Ansprüche, wobei die Sperrschicht und die Elektrode (21), die die obere elektroaktive Schicht (31) von der unteren elektroaktiven Schicht (30) trennt, ein und dieselbe Schicht bilden, wobei die Elektrode die nichtmetallische Verbindung umfasst, die die UV-Strahlen absorbiert oder sperrt.

11. Verfahren nach einem der vier vorstehenden Ansprüche, wobei die Bildung der Elektrode (21) einen Schritt des Abscheidens einer metallischen Lösung durch Tintenstrahl, Siebdruck oder durch Ultraschallzerstäubung umfasst, wobei das Bilden der Sperrschicht das Integrieren der Thiolbindungen in die metallische Lösung umfasst, und wobei das Integrieren unter Mischen der Thiolbindungen mit der metallischen Lösung vor dem Abscheiden der metallischen Lösung durchgeführt wird.

12. Verfahren nach einem der Ansprüche 7 bis 9, wobei die Sperrschicht eine Schicht ist, die von der Elektrode (21) getrennt ist, welche die obere elektroaktive Schicht (31) von der unteren elektroaktiven Schicht (30) trennt, wobei die Sperrschicht zwischen der Elektrode (21) und einer aus der oberen elektroaktiven Schicht (31) und der unteren elektroaktiven Schicht (30) liegt.

13. Verfahren nach einem der vorstehenden Ansprüche, wobei der Stapel mehr als zwei Elektroden (20, 21, 22) umfasst, und wobei nur zwei elektrische Kontakte gebildet werden, die dafür konfiguriert sind, eine Potentialdifferenz über die Gesamtheit des Stapels anzulegen.

14. Elektro-Aktuator, der einen Stapel umfasst, welcher eine Vielzahl von übereinanderliegenden elektroaktiven Schichten umfasst, die jede mit zwei Elektroden assoziiert sind, **dadurch gekennzeichnet, dass** mindestens gewisse der elektroaktiven Schichten ein elektroaktives Polymer umfasst, das unter der Wirkung einer Exposition gegenüber einer ultravioletten Strahlung mindestens zum Teil kristallisieren kann, und dadurch, dass er zwischen zwei übereinanderliegenden elektroaktiven Schichten mindestens eine Schicht umfasst, die mindestens eine nichtmetallische Verbindung umfasst, welche die UV-Strahlen absorbiert oder sperrt.

15. Vorrichtung, die einen oder mehrere Elektro-Aktuatoren nach einem der zwei vorstehenden Ansprüche umfasst.

## Claims

1. Method for manufacturing an electroactive actuator from a stack comprising at least one first electrode (20) and at least one layer comprising an electroactive polymer surmounting the electrode (20), the electroactive polymer having the ability to respond by a movement when it is in a crystalline state and an electrical field is applied thereto, the method comprising:
- a step of obtaining an electroactive layer (30) comprising a step of crystallisation of the layer comprising the electroactive polymer surmounting the stack;
- a step of formation of a second electrode (21) so that the electroactive layer (30) is disposed between the two electrodes (20, 21);
**characterised in that** the electroactive polymer is formed from a material able to at least partly crystallise under the effect of exposure to ultraviolet (UV) radiation and **in that** the crystallisation step comprises a step of exposing the electroactive layer (30) to ultraviolet radiation in the course of which at least part of the ultraviolet radiation is delivered in the form of one or more pulses, the duration of each pulse being less than 100 milliseconds (ms) (10⁻³seconds), and wherein, from the stack comprising at least one layer comprising an electroactive polymer disposed between two electrodes (20, 21), the following sequence of steps is performed:
- formation of an additional layer of electroactive polymer surmounting said stack;
- obtaining an additional electroactive layer (31) by crystallisation of said additional layer of electroactive polymer, the crystallisation comprising a step of exposing the additional layer of electroactive polymer to UV radiation, the exposure step comprising the pulse or pulses;
- formation of an electrode (22) surmounting said additional electroactive layer (31).

2. Method according to the preceding claim, wherein said sequence of steps is reiterated so as to obtain a stack of a plurality of electroactive layers (30, 31) each being the subject of an independent step of exposure of the electroactive layer (30) to ultraviolet radiation and each situated between two electrodes (20, 21, 22).

3. Method according to the preceding claim, wherein the plurality of electroactive layers comprises at least three electroactive layers and preferably at least five electroactive layers.

4. Method according to any of the preceding claims, wherein the duration of each pulse is less than 10 ms and preferably less than 3 ms, and wherein the duration of exposure is between 0.5 ms and 3 ms and preferably between 0.5 ms and 2 ms, and wherein, during the exposure step, the ultraviolet radiation is delivered in the form of one or more pulses, the fluence of each of the pulses being less than 50 J/cm² and preferably being between 2 J/cm² and 40 J/cm² and preferably between 5 J/cm² and 30 J/cm² and preferably between 15 J/cm² and 20 J/cm².

5. Method according to any of the preceding claims, wherein the crystallisation step comprises solely said exposure step, and wherein the electroactive layer (30) preferably consists only of electroactive polymer.

6. Method according to any of the preceding claims, wherein the stack rests on a substrate (10) that is sufficiently flexible to follow the movement of the stack.

7. Method according to any of the preceding claims, wherein the stack comprises a plurality of electroactive layers (30, 31) and wherein, after crystallisation of a lower electroactive layer (30) and before the formation of a second upper electroactive layer (31) surmounting the lower electroactive layer (30), a UV-blocking layer is produced, disposed between the lower and upper electroactive layers, said blocking layer comprising at least one non-metallic compound absorbing or blocking UV, so that the UV-blocking layer blocks at least part of the UV passing through the upper electroactive layer and directed towards the lower electroactive layer, and wherein the UV-blocking layer blocks at least 50% and preferably at least 70% and preferably at least 90% of the UV passing through the upper electroactive layer and directed towards the lower electroactive layer.

8. Method according to the preceding claim, wherein the non-metallic compound absorbing or blocking UV is an organic compound comprising a thiol bond (-SH).

9. Method according to the preceding claim, wherein the blocking layer is formed by the electrode (21) separating the upper electroactive layer (31) from the lower electroactive layer (30), wherein the non-metallic compound absorbing or blocking UV preferably forms a thiol bond (-SH) and wherein the concentration of thiol bonds in the electrode (21) is preferably between 0.5% and 10% by weight and preferably between 1% and 5% by weight.

10. Method according to any of the preceding three claims, wherein the blocking layer and the electrode (21) separating the upper electroactive layer (31) from the lower electroactive layer (30) form one and the same layer, said electrode comprising the non-metallic compound absorbing or blocking UV.

11. Method according to any of the preceding four claims, wherein the formation of the electrode (21) comprises a step of depositing a metallic solution by inkjet, screen printing or ultrasonic sputtering, wherein the formation of the blocking layer comprises the incorporation of the thiol bonds in the metallic solution, and wherein the incorporation is carried out by mixing the thiol bonds with the metallic solution before deposition of the metallic solution.

12. Method according to any of claims 7 to 9, wherein the blocking layer is a layer distinct from the electrode (21) separating the upper electroactive layer (31) from the lower electroactive layer (30), the blocking layer being situated between said electrode (21) and either the upper electroactive layer (31) or the lower electroactive layer (30).

13. Method according to any of the preceding claims, wherein the stack comprises more than two electrodes (20, 21, 22) and wherein only two electrical contacts are formed, configured to apply a potential difference to the whole of the stack.

14. Electroactuator comprising a stack comprising a plurality of superimposed electroactive layers, each associated with two electrodes, **characterised in that** at least some of the electroactive layers comprise an electroactive polymer able to at least partly crystallise under the effect of exposure to ultraviolet radiation and **in that** it comprises, between two superimposed electroactive layers, at least one layer comprising at least one non-metallic compound absorbing or blocking UV.

15. Device comprising one or more electroactuators according to either of the preceding two claims.
